# EUROPEAN PATENT APPLICATION

(11) **EP 3 327 755 A1**
(43) Date of publication of application: **30.05.2018**
(21) Application number: 16891896.9
(22) Date of filing: 10.10.2016
(51) Int. Cl.: H01L 21/56, H01L 23/31, H01L 23/28, H01L 23/02

(54) **CHIP PACKAGING STRUCTURE AND CHIP PACKAGING METHOD**

(71) Applicant: Shenzhen Goodix Technology Co., Ltd., Futian Free Trade Zone Shenzhen, Guangdong 518000 (CN)
(72) Inventor: LONG, Wei, Shenzhen, Guangdong 518000 (CN); WU, Baoquan, Shenzhen, Guangdong 518000 (CN); LIU, Xiangying, Shenzhen, Guangdong 518000 (CN)
(74) Representative: Valea AB
(86) International application number: PCT/CN2016/101627
(87) International publication number: WO 2018/068174

(57) **Abstract**

A chip packaging structure includes: at least one package, each of the at least one package comprising at least one chip; and an expansion body wrapping the package and being cuttable according to a package size requirement. A chip packaging method includes: fixing at least one package to a lower mold surface via a carrier, and sealing an upper mold for the package; and fully filling a cavity between the carrier and the upper mold with an expansion body by plastic injection molding, the expansion body wrapping the at least one package; and releasing the mold to obtain a size-expanded package, and cutting the package according to a package size need. Another chip packaging method includes: pre-fabricating a hollow frame having hollow regions, and placing the hollow frame on a surface of the lower mold; placing at least one package in the hollow regions of the hollow frame respectively, and filling a gap between the package and the hollow frame where the package is positioned with an expansion body, such that the expansion body wraps the package; and curing to obtain a size-expanded package, and cutting the package according to a package size need. The present application achieves size-variable chip packaging.

## Description

### TECHNICAL FIELD

The present application relates to the technical field of IC designs, and in particular, relates to a chip packaging structure and a chip packaging method.

### BACKGROUND

Chip packaging is a technique of packaging an integrated circuit with an insulating material such as plastic or ceramic. Using a CPU as an example, the practically observed volume and appearance are not the size and appearance of a real CPU core, but a product obtained by packaging the CPU core and the like devices. Chip packaging is mandatory for chips and is also very significant. This is because the chip needs to be isolated from the outside to prevent impurities in the air from causing corrosion to the chip circuit and thus causing degradation of the electrical properties thereof. In another aspect, the packaged chip is more convenient for installation and transportation. The packaging technique directly affects the play of the performance of the chip and the design and manufacture of the printed circuit board (PCB) connected thereto. Therefore, the packaging is very important.

With the developments of technology and market, small-sized sensor chips are prevailing in the market due to a better balance of the volume, security and cost thereof. However, during design of such sensor chips, some specific size requirements may be imposed in terms of visual beauty, touch feeling and the like. The development of specific-size sensor chips is in conflict with the development of the small-size sensor chips. Increase of the size of the sensor chip may greatly increase the cost. Likewise, more size demands of the sensor chips suffer from problem of compatibility.

### SUMMARY

The present application provides a chip packaging structure and a chip packaging method, which may achieve size-variable chip packaging.

Embodiments of the present application provide a chip packaging structure, including: at least one package, each of the at least one package including at least one chip; and an expansion body wrapping the package and being cuttable according to a package size requirement.

Embodiments of the present application further provide a chip packaging method, including:
fixing at least one package to a lower mold surface via a carrier, and sealing an upper mold for the package;
fully filling a cavity between the carrier and the upper mold with an expansion body by plastic injection molding, the expansion body wrapping the at least one package; and
releasing the mold to obtain a size-expanded package, and cutting the package according to a package size need.

Embodiments of the present application further provide another chip packaging method, including:
pre-fabricating a hollow frame having a hollow region, and placing the hollow frame on a surface of the lower mold;
placing at least one package in the hollow regions of the hollow frame respectively, and filling a gap between the package and the hollow frame where the package is positioned with an expansion body, such that the expansion body wraps the package; and
curing to obtain a size-expanded package, and cutting the package according to a package size need.

As known from embodiments of the present application, in the present application, at least one package is wrapped by an expansion body, and the expansion body may be cut according to a package size need. Therefore, the expansion body may be cut according to the package size requirement, to obtain a packaged chip having a specific size. The present application overcomes the conflict between packaging of small-sized chips and packaging of other-sized chips, and satisfies the demand of product differences.

### BRIEF DESCRIPTION OF THE DRAWINGS

To more clearly describe technical solutions according to the embodiments of the present application or in the prior art, drawings that are to be referred for description of the embodiments or the prior art are briefly described hereinafter. Apparently, the drawings described hereinafter merely illustrate some embodiments of the present application. Persons of ordinary skill in the art may also derive other drawings based on the drawings described herein without any creative effort.
FIG. 1A and FIG. 1B are schematic diagrams of a packaged chip according to some embodiments of the present application;
FIG. 2A to FIG. 2F are flowcharts of a chip packaging method according to some embodiments of the present application;
FIG. 3 is a schematic diagram of a carrier in the chip packaging method according to the present application;
FIG. 4 is a schematic diagram illustrating fixing a package using the carrier in the chip packaging method according to the present application;
FIG. 5 is a schematic diagram illustrating sealing an upper mold in the chip packaging method according to the present application;
FIG. 6 is a schematic diagram illustrating filling with an expansion body in the chip packaging method according to the present application;
FIG. 7 is a schematic diagram illustrating releasing the mold to obtain a packaged chip in the chip packaging method according to the present application;
FIG. 8A and FIG. 8B are schematic diagrams illustrating a non-aligned upper surface of the expansion body and an upper surface of an IC package in the chip packaging method according to the present application;
FIG. 9 are schematic diagrams illustrating an upper surface of the expansion body and an upper surface of the package upon grinding in the chip packaging method according to the present application;
FIG. 10A to FIG. 10B are flowcharts of a chip packaging method according to some other embodiments of the present application;
FIG. 11 is a schematic diagram illustrating a strip-like glass fiber in the chip packaging method according to the present application;
FIG. 12 is a schematic diagram illustrating pre-fabricating to form a frame with partially hollowed regions in the chip packaging method according to the present application;
FIG. 13 is a schematic diagram illustrating placing the package into the hollow regions of the glass fiber hollow frame in the chip packaging method according to the present application;
FIG. 14 is a schematic diagram illustrating curing to obtain a secondary package in the chip packaging method according to the present application;
FIG. 15 is a schematic diagram illustrating a non-aligned upper surface of the expansion body and an upper surface of an IC package in the chip packaging method according to the present application; and
FIG. 16 is a schematic diagram illustrating an upper surface of the expansion body and an upper surface of the IC package upon grinding in the chip packaging method according to the present application.

### DETAILED DESCRIPTION

In the present application, at least one package is wrapped by an expansion body, and the expansion body may be cut according to a package size need. Therefore, the expansion body may be cut according to the package size requirement, to obtain a packaged chip having a specific size. The present application overcomes the conflict between packaging of small-sized chips and packaging of other-sized chips, and satisfies the demand of product differences.

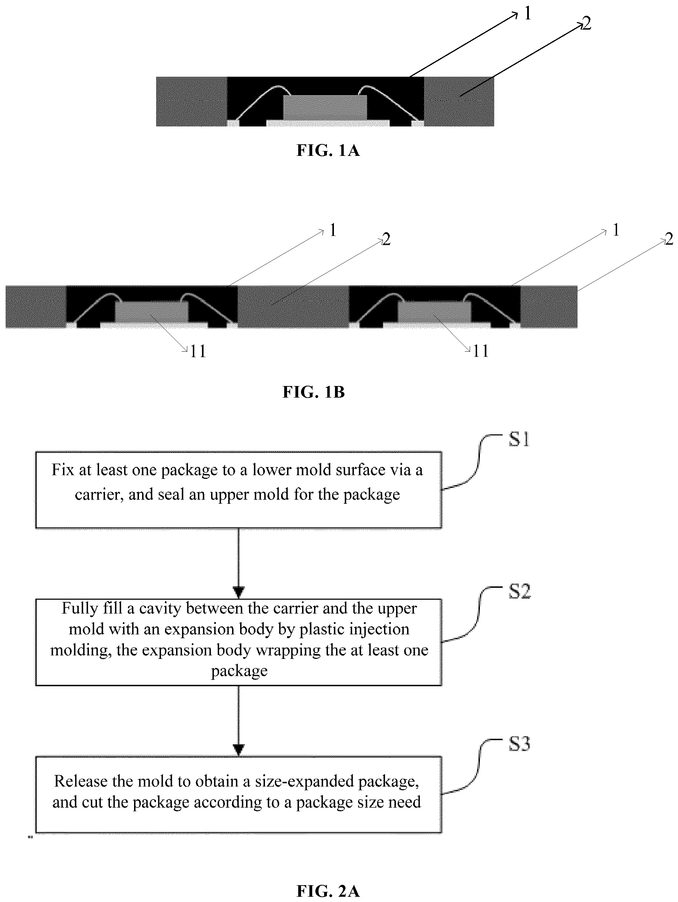

Referring to FIG. 1A and FIG. 1B, the present application provides a chip packaging structure, including: at least one package 1, each of the at least one package 1 including at least one chip 11; and an expansion body 2 wrapping the package 1 and being cuttable according to a package size requirement.

Therefore, according to the present application, the expansion body may be cut according to the package size requirement, to obtain a packaged chip having a specific size. The present application overcomes the conflict between packaging of small-sized chips and packaging of other-sized chips, and satisfies the demand of product differences.

In a specific embodiment of the present application, the expansion body 2 wraps four side faces of the package 1, such that the expansion body 2 wraps the package 1.

In another specific embodiment of the present application, the expansion body 2 is not lower than an upper surface of the package 1.

Specifically, the expansion body 2 is aligned with the upper surface of the package 1.

Through grinding, the upper surface of the package 1 is aligned with the upper surface of the expansion body 2. In this way, a flatness is retained therebetween, and in addition, a distance from the surface of the packaged die to the IC surface may be controlled.

In another specific embodiment of the present application, the expansion body 2 is made from a plastic injection molding material or a frame filling material such that the expansion body 2 wraps the package 1.

In another specific embodiment of the present application, the expansion body 2 has a thermal expansion coefficient that is the same as thermal expansion coefficients of a plastic package 1 of the package, a lead frame, a substrate and a chip silicon material, such that the case where the packaged chip may not be used due to different thermal expansion coefficients is avoided.

In another specific embodiment of the present application, a surface of the packaged chip packaged by the expansion body 2 is provided with an attachment portion configured to enhance an attachment force with a printed circuit board. The attachment portion is specifically a placed solder ball, a dummy pad or the like, which enhances the attachment force between the packaged chip packaged with the expansion body 2 and the printed circuit board.

In another specific embodiment of the present application, the expansion body 2 is gray or in the like color which is easy to process subsequently. The specific color may be customized according to actual needs.

In another specific embodiment of the present application, the expansion body 2 includes a discrete device, and/or a conductive vias module therein. That is, the discrete device and/or the conductive vias module is placed at the surrounding of the package 1, and the gap is filled with the expansion body 2, such that the expansion body 2 wraps the package 1 and the discrete device.

In another specific embodiment of the present application, before packaging using the expansion body 2, a lower surface of the package 1 is provided with a pad film or sprayed with a water-soluble adhesive, to prevent adhesive spill pollution and overcome the impact caused to rear-end attachment.

In another specific embodiment of the present application, an upper surface of the package 2 is provided with a cover. The cover is made from glass, ceramic, sapphire or the like, such that the expansion body 2 plastically packages and molds the cover and the package 1.

In another specific embodiment of the present application, the package 1 is one of a quad flat no-lead package, a grid array package, and a wafer level package.

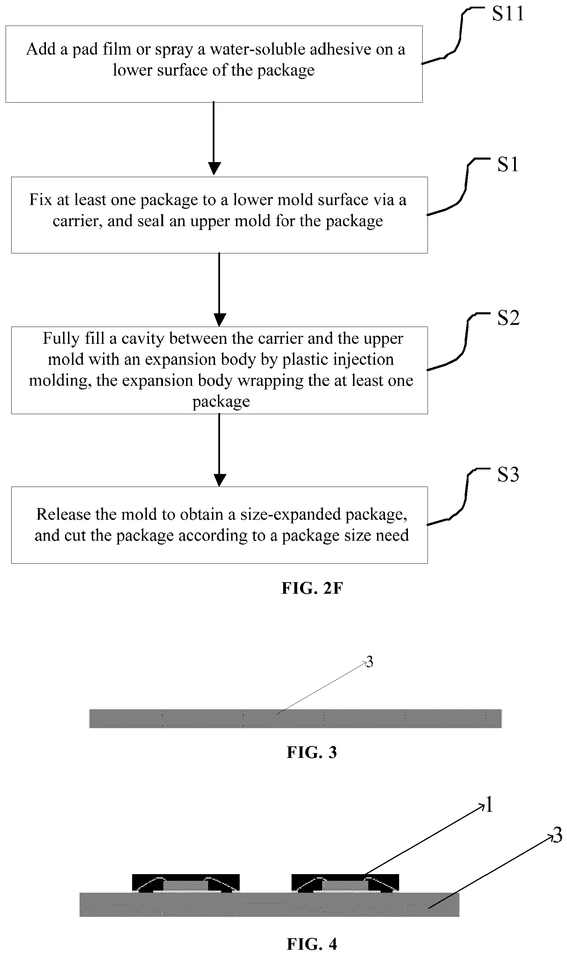

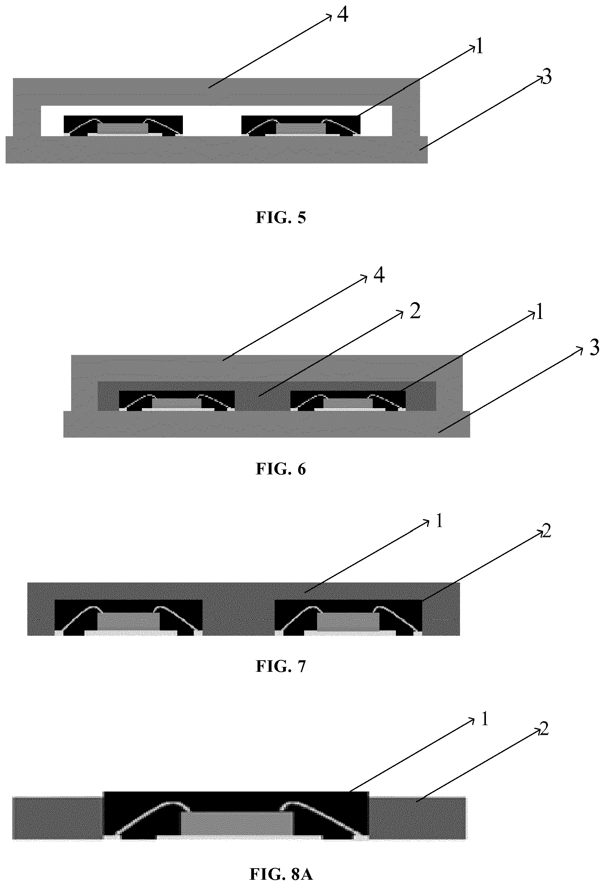

Referring to FIG. 2A, a specific embodiment of the chip packaging method according to the present application includes the following steps:
S1: At least one package is fixed to a lower mold surface via a carrier, and an upper mold is sealed for the package.
   A flat plate that may be used as a support is prepared to act as a carrier 3, as illustrated in FIG. 3. The package 1 is fixed by using the carrier 3, as illustrated in FIG. 4. An upper mold 4 is sealed for the package 1 on the carrier 3, as illustrated in FIG. 5.
S2: A cavity between the carrier and the upper mold is fully filled with an expansion body by plastic injection molding, where the expansion body wrapping the at least one package.
   Specifically, the expansion body 2 is filled to the surrounding of the package 1 by plastic injection molding, such that the expansion body 2 wraps the package 1, as illustrated in FIG. 6.
S3: The mold is released to obtain a size-expanded package, and the package is cut according to a package size need.

The mold is released to obtain a size-expanded packaged chip, as illustrated in FIG. 7.

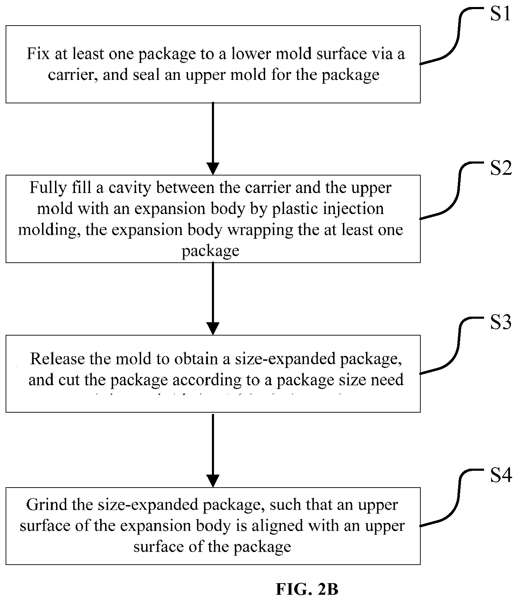

In another specific embodiment of the present application, referring to FIG. 2B, the method further includes: S4: grinding the size-expanded package, such that an upper surface of the expansion body is aligned with an upper surface of the package.

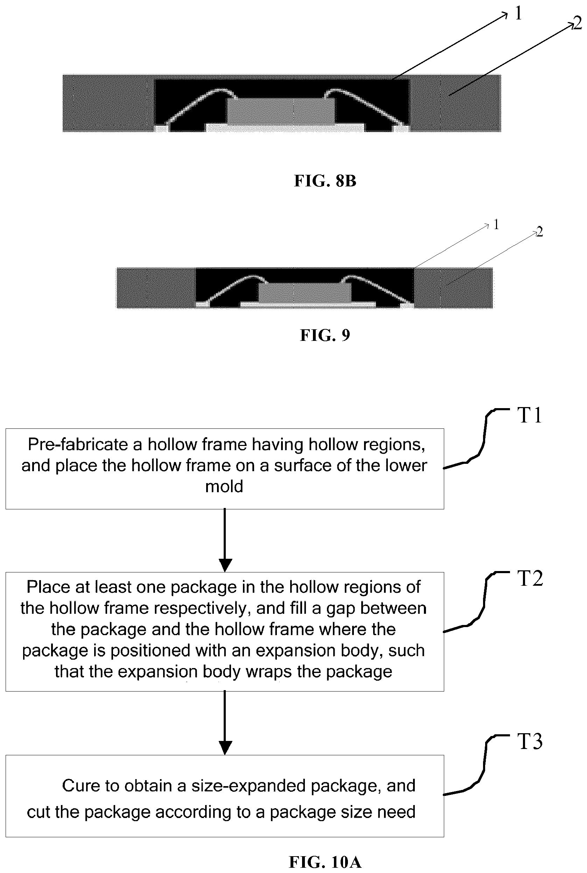

The upper surface of the expansion body 2 that is not aligned with the upper surface of the IC package 1 are as illustrated in FIG. 8, and the upper surface of the ground expansion body 2 and the upper surface of the package 1 are as illustrated in FIG. 9.

Through grinding, the upper surface of the expansion body 2 and the upper surface of the IC package 1 are on the same plane. In this way, a flatness is retained therebetween, and in addition, a distance from the surface of the packaged die to the IC surface may be controlled.

In another specific embodiment of the present application, step S2 specifically includes:
fully filling the cavity between the carrier and the upper mold with the expansion body by plastic injection molding, the expansion body wrapping one package; or
fully filling the cavity between the carrier and the upper mold with the expansion body by full-board plastic injection molding, the expansion body wrapping a plurality of packages.

According to the present application, the expansion body 2 may be filled with respect to a single package 1, thereby directly forming a desired package size. In addition, the expansion body 2 may be filled with respect a plurality of packages 1, and then the plurality of packages 1 upon expansion may be cut to obtain individual packages 1 each having the desired package size.

Package efficiency is improved by filling the expansion body 2 for a plurality of spliced packages and then cutting the package into individual packages 1.

The expansion body 2 is made from a full-board plastic inject molding material, which may prevent the large board used by the expansion body 2 from warpage.

Specifically, the expansion body 2 is made from a plastic inject molding material.

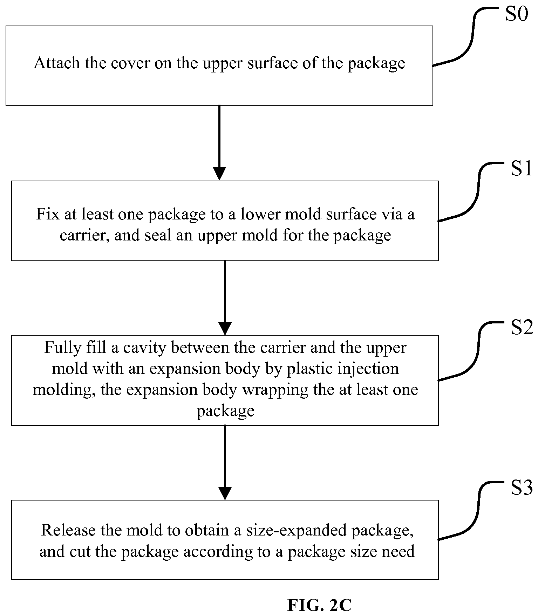

In a specific embodiment of the present application, referring to FIG. 2C, prior to step S1, the method further includes:
S0: attaching the cover on the upper surface of the package.

The cover is made from glass, ceramic, sapphire or the like, such that the expansion body 2 plastically packages and molds the cover and the package 1.

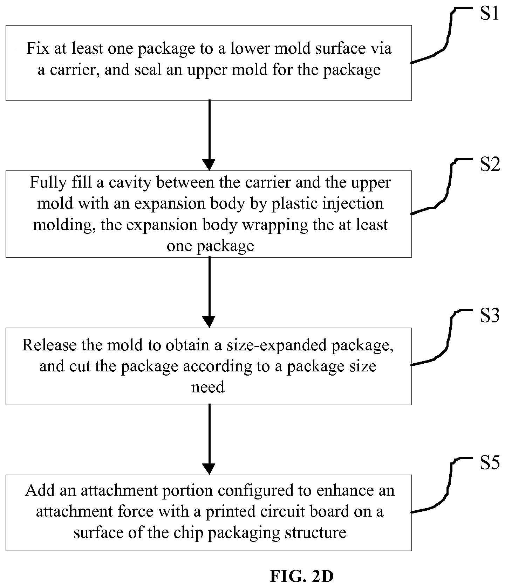

In a specific embodiment of the present application, referring to FIG. 2D, upon step S3, the method further includes: S5: adding an attachment portion configured to enhance an attachment force with a printed circuit board on a surface of the packaged chip.

The attachment portion is specifically a placed solder ball, a dummy pad or the like, which enhances the attachment force between the packaged chip packaged with the expansion body 2 and the printed circuit board.

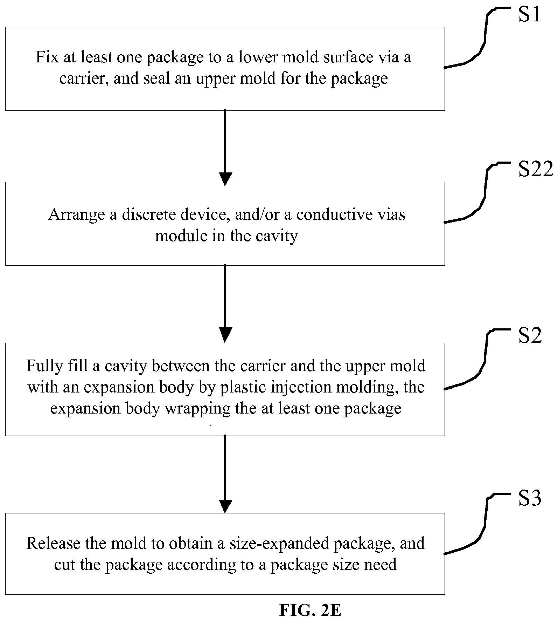

In a specific embodiment of the present application, referring to FIG. 2E, prior to step S2, the method further includes:
S22: arranging a discrete device, and/or a conductive vias module in the cavity.

In a specific embodiment of the present application, referring to FIG. 2F, prior to step S1, the method further includes:
S1 1: adding a pad film or spraying a water-soluble glue on a lower surface of the package.

In this way, adhesive spill pollution is prevented and the impact caused to rear-end attachment is overcome.

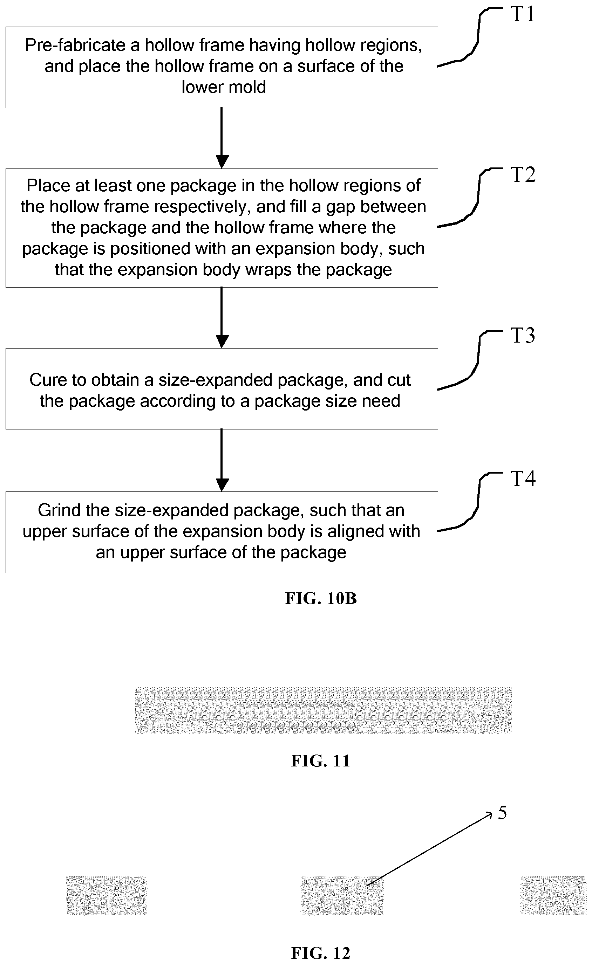

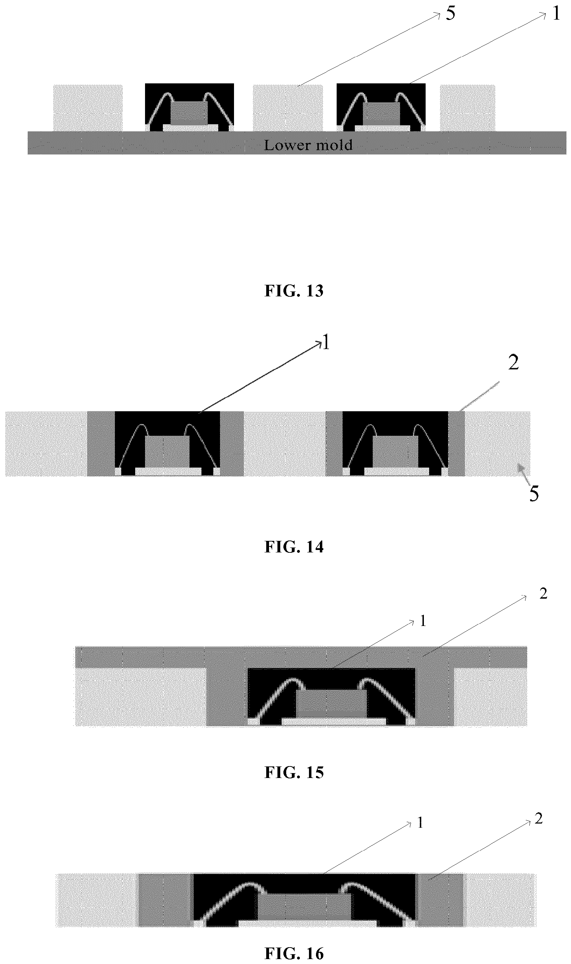

Referring to FIG. 10A, another specific embodiment of the chip packaging method according to the present application includes the following steps:
T1: A hollow frame having a hollow region is pre-fabricated, and the hollow frame is placed on a surface of the lower mold.
   Specifically, pre-fabrication is carried out on a strip-like glass fiber to form a frame 5 with partially hollowed regions. The strip-like glass fiber is as illustrated in FIG. 11, and the pre-fabricated frame with partially hollowed regions is as illustrated in FIG. 12.
T2: At least one package is placed in the hollow regions of the hollow frame respectively, and a gap between the package and the hollow frame where the package is positioned is filled with an expansion body, such that the expansion body wraps the package.
   Specifically, the package 1 is placed in the hollow region of the glass fiber hollow frame 5, as illustrated in FIG. 13. The filling the gap between the package 1 and the hollow frame 5 wherein the package 1 is positioned with the expansion body 2 specifically includes: suspension-coating the expansion body to the gap between the package 1 and the hollow frame 5 wherein the package 1 is positioned.
T3: A size-expanded package is obtained upon curing, and the package is cut according to a package size need.
   The size-expanded package obtained via curing is as illustrated in FIG. 14, and may be freely cut according to the package size need to obtain a secondary package having a specific size.
   In a specific embodiment of the present application, referring to FIG. 10B, the method further includes:
T4: The size-expanded package is ground, such that an upper surface of the expansion body is aligned with an upper surface of the package.

If the upper surface of the expansion body 2 is not aligned with the upper surface of the package 1, grinding is performed to make the upper surfaces to be aligned with each other.

The upper surface of the expansion body 2 that is not aligned and the upper surface of the IC package 1 are as illustrated in FIG. 15, and the upper surface of the ground expansion body 2 and the upper surface of the IC package 1 are as illustrated in FIG. 16.

Through grinding, the upper surface of the expansion body 2 and the upper surface of the IC package 1 are on the same plane. In this way, a flatness is retained therebetween, and in addition, a distance from the surface of the packaged die to the IC surface may be controlled.

It should be noted that, with respect to the above described method embodiments, for brevity of description, the actions or steps are all described as a series of action combinations. However, a person skilled in the art shall understand that the embodiments of the present application are not subjected to limitations of the action sequences described above. Further, based on the embodiments of the present application, some steps may be performed in another or other sequences or may be simultaneously performed. In addition, a person skilled in the art should also know that the embodiments described in the description herein are all preferred embodiments, and all the involved actions and modules are not mandatory ones of the embodiments of the present application.

In the above embodiments, descriptions give different particular emphases to various embodiments, and the portion of some embodiment that is not described may be referenced to the relevant description in other embodiments.

Detailed above describes a method for switching working mode of a headphone and a headphone. A person skilled in the art would derive various modifications to the specific embodiments and application scope thereof based on the inventive concept of the embodiments of the present application. In conclusion, the disclosure of this specification shall not be construed to limit the present application.

## Claims

1. A chip packaging structure, comprising: at least one package, each of the at least one package comprising at least one chip; and an expansion body wrapping the package and being cuttable according to a package size requirement.

2. The chip packaging structure according to claim 1, wherein the expansion body wraps four side faces of the package.

3. The chip packaging structure according to claim 1, wherein the expansion body is not lower than an upper surface of the package.

4. The chip packaging structure according to claim 3, wherein the expansion body is aligned with the upper surface of the package.

5. The chip packaging structure according to any one of claims 1 to 4, wherein the expansion body is made from a plastic injection molding material or a frame filling material.

6. The chip packaging structure according to claim 5, wherein the expansion body has a thermal expansion coefficient that is the same as thermal expansion coefficients of a plastic package of the package, a lead frame, a substrate and a chip silicon material.

7. The chip packaging structure according to claim 1, wherein a surface of the chip packaging structure is provided with an attachment portion configured to enhance an attachment force with a printed circuit board.

8. The chip packaging structure according to claim 1, wherein the expansion body is an expansion body having a requirement-based customized color.

9. The chip packaging structure according to claim 1, wherein the expansion body comprises a discrete device, and/or a conductive vias module.

10. The chip packaging structure according to claim 1, wherein a lower surface of the package is provided with a pad film or sprayed with a water-soluble adhesive.

11. The chip packaging structure according to claim 1, wherein an upper surface of the package comprises a cover.

12. The chip packaging structure according to any one of claims 1 to 11, wherein the package is one of a quad flat no-lead package, a grid array package, and a wafer level package.

13. A chip packaging method, comprising:
fixing at least one package to a lower mold surface via a carrier, and sealing an upper mold for the package;
fully filling a cavity between the carrier and the upper mold with an expansion body by plastic injection molding, the expansion body wrapping the at least one package; and
releasing the mold to obtain a size-expanded package, and cutting the package according to a package size need.

14. The chip packaging method according to claim 13, further comprising: grinding the size-expanded package, such that an upper surface of the expansion body is aligned with an upper surface of the package.

15. The chip packaging method according to claim 13, wherein the fully filling a cavity between the carrier and the upper mold with an expansion body by plastic injection molding, the expansion body wrapping the at least one package comprises:
fully filling the cavity between the carrier and the upper mold with the expansion body by plastic injection molding, the expansion body wrapping one package; or
fully filling the cavity between the carrier and the upper mold with the expansion body by full-board plastic injection molding, the expansion body wrapping a plurality of packages.

16. The chip packaging method according to claim 15, wherein the expansion body is made from a plastic injection molded material.

17. The chip packaging method according to claim 13, wherein prior to the fixing at least one package to a lower mold surface via a carrier, and sealing an upper mold for the package, the method further comprises:
attaching the cover on the upper surface of the package.

18. The chip packaging method according to claim 13, wherein upon the releasing the mold to obtain a size-expanded package, the method further comprises:
adding an attachment portion configured to enhance an attachment force with a printed circuit board on a surface of the chip packaging structure.

19. The chip packaging method according to claim 13, wherein prior to the fully filling a cavity between the carrier and the upper mold with an expansion body by plastic injection molding, the expansion body wrapping the at least one package, the method further comprises:
arranging a discrete device, and/or a conductive vias module in the cavity.

20. The chip packaging method according to claim 13, wherein prior to the fixing at least one package to a lower mold surface via a carrier, and sealing an upper mold for the package, the method further comprises:
adding a pad film or spraying a water-soluble adhesive on a lower surface of the package.

21. A chip packaging method, comprising:
pre-fabricating a hollow frame having hollow regions, and placing the hollow frame on a surface of a lower mold;
placing at least one package in the hollow regions of the hollow frame respectively, and filling a gap between the package and the hollow frame where the package is positioned with an expansion body, such that the expansion body wraps the package; and
curing to obtain a size-expanded package, and cutting the package according to a package size need.

22. The chip packaging method according to claim 21, wherein the filling a gap between the package and the hollow frame where the package is positioned with an expansion body comprises: suspension-coating the expansion body to the gap between the package and the hollow frame where the package is positioned.

23. The chip packaging method according to claim 21, further comprising: grinding the size-expanded package, such that an upper surface of the expansion body is aligned with an upper surface of the package.
